# EUROPEAN PATENT APPLICATION

(11) **EP 4 646 080 A2**
(43) Date of publication of application: **05.11.2025**
(21) Application number: 25173285.5
(22) Date of filing: 29.04.2025
(51) Int. Cl.: H10K 59/122, H10K 59/131, H10K 59/80

(54) **DISPLAY DEVICE AND ELECTRONIC DEVICE COMPRISING DISPLAY DEVICE**

(30) Priority: 02.05.2024 KR 20240058555
(71) Applicant: Samsung Display Co., Ltd., Yongin-si, Gyeonggi-do 17113 (KR)
(72) Inventor: KIM, Kyung Bae, 17113 Yongin-si (KR); PARK, Kyeong Min, 17113 Yongin-si (KR); LEE, Yong Hee, 17113 Yongin-si (KR); HA, Jin Joo, 17113 Yongin-si (KR)
(74) Representative: Marks & Clerk LLP

(57) **Abstract**

A display device may include: a pixel circuit layer including a substrate on a plane, a pixel circuit on the substrate, a data line electrically connected to the pixel circuit, and a via layer covering the pixel circuit and the data line; a light emitting element on the pixel circuit layer, and including an anode electrode, a cathode electrode, and an emission structure electrically connected between the anode electrode and the cathode electrode; and a pixel defining layer on the pixel circuit layer, and covering a portion of the anode electrode. A trench passing both (e.g., simultaneously) through the pixel defining layer and through a portion of the via layer may be in an area adjacent to the anode electrode. The trench may be between the anode electrode and the data line if (e.g., when) viewed on the plane.

## Description

### BACKGROUND

### 1. Field

One or more embodiments of the present disclosure relate to a display device and an electronic device comprising the display device.

### 2. Description of Related Art

Recently, with the growing interest in information displays, continuous research and development have been conducted on display devices. These display devices may include a light source, such as an organic light emitting diode (OLED).

Electrical signals for driving an organic light emitting element may be supplied based on two or more conductive structures. These electrical signals may interfere with each other, potentially leading to distortion in the signals supplied to operate the organic light-emitting element (e.g., there may be a risk of the electrical signals supplied to operate the organic light emitting element being distorted.) Accordingly, to provide a high-quality display device, a structure with improved reliability of electrical signals is desired or required.

### SUMMARY

An aspect of the present disclosure is directed to a display device and an electronic device comprising the display device with improved reliability of electrical signals.

An aspect of the present disclosure is directed to a display device and an electronic device comprising the display device capable of improving power consumption characteristics.

Additional aspects will be set forth in part in the description which follows and, in part, will be apparent from the description, or may be learned by practice of the presented embodiments of the disclosure.

One or more embodiments of the present disclosure are directed towards a display device, including: a pixel circuit layer including a substrate arranged on a plane, a pixel circuit formed on the substrate, a data line electrically connected to the pixel circuit, and a via layer covering the pixel circuit and the data line; a light emitting element arranged on the pixel circuit layer, and including an anode electrode, a cathode electrode, and an emission structure electrically connected between the anode electrode and the cathode electrode; and a pixel defining layer arranged on the pixel circuit layer, and covering a portion of the anode electrode. A trench passing both (e.g., simultaneously) through the pixel defining layer and through a portion of the via layer may be formed in an area adjacent to the anode electrode. The trench may be arranged between the anode electrode and the data line when viewed in a plan view of the display device (or on the plane (e.g., in a plan view)).

In one or more embodiments, an imaginary line connecting the anode electrode and the data line may pass through the trench.

In one or more embodiments, an air layer may be formed in the trench.

In one or more embodiments, the display device may further include an emission area where the light emitting element provides light. The trench may be formed in a peripheral portion of the emission area.

In one or more embodiments, the display device may further include: a first sub-pixel to provide light of a first color; a second sub-pixel to provide light of a second color; and a third sub-pixel to provide light of a third color. The emission area may include a first emission area corresponding to (forming) the first sub-pixel, a second emission area corresponding to (forming) the second sub-pixel, and a third emission area corresponding to (forming) the third sub-pixel. The trench may include a first trench enclosing the first emission area, a second trench enclosing the second emission area, and a third trench enclosing the third emission area.

In one or more embodiments, the pixel circuit may include a first pixel circuit included in the first sub-pixel, a second pixel circuit included in the second sub-pixel, and a third pixel circuit included in the third sub-pixel. The data line may include a first data line electrically connected to the first pixel circuit, a second data line electrically connected to the second pixel circuit, and a third data line electrically connected to the third pixel circuit.

In one or more embodiments, the first emission area, the second emission area, and the third emission area may be adjacent to each other in a first direction. The first data line, the second data line, and the third data line may be extended in a second direction different from the first direction, and may be arranged on one side of the first emission area, on one side of the second emission area, and on one side of the third emission area, respectively. In other words, the first, second, and third data lines may extend in a second direction different from the first direction and may be positioned on one side of the first, second, and third emission areas, respectively.

In one or more embodiments, each of the first emission area, the second emission area, and the third emission area may have a rectangular shape.

In one or more embodiments, the second emission area and the third emission area may be adjacent to each other in a first direction. The first emission area may be adjacent to the second emission area and the third emission area in a diagonal direction inclined to both (e.g., simultaneously) the first direction and a second direction normal (e.g., perpendicular) to the first direction.

In one or more embodiments, at least a portion of the data line may be extended in the diagonal direction, and at least another portion of the data line may be extended in the second direction.

In one or more embodiments, the data line may be in a form of a single line in each of an area between the first trench and the second trench and an area between the first trench and the third trench. The data line may be in a form of a plurality of lines in an area between the second trench and the third trench.

In one or more embodiments, between the first trench and the second trench, a portion of the second data line may be arranged without the first data line and the third data line being arranged. Between the first trench and the third trench, a portion of the first data line may be arranged without the second data line and the third data line being arranged. Between the second trench and the third trench, a portion of the first data line and a portion of the second data line may be arranged without the third data line being arranged. In other words, a portion of the second data line may be positioned between the first and second trenches without the first and third data lines. Similarly, a portion of the first data line may be positioned between the first and third trenches without the second and third data lines. Additionally, portions of the first and second data lines may be positioned between the second and third trenches without the third data line.

In one or more embodiments, each of the first emission area, the second emission area, and the third emission area may have a hexagonal shape.

In one or more embodiments, the substrate may include a silicon substrate. At least a portion of the emission structure may be disconnected by the trench.

In one or more embodiments, the pixel circuit may include a transistor. The transistor may be electrically connected to the anode electrode through two or more conductive layers.

In one or more embodiments, no conductive structure may be formed between the data line and the pixel defining layer.

In one or more embodiments, the display device may further include a data connection conductive layer arranged between the substrate and the data line. A data signal supplied through the data line may be applied to the data connection conductive layer arranged under the data line.

In one or more embodiments, the two or more conductive layers may include a lower conductive layer, and the lower conductive layer may electrically connect the transistor and the anode electrode to each other.

In one or more embodiments, the two or more conductive layers may further include an upper conductive layer arranged on the lower conductive layer, and electrically connect the lower conductive layer and the anode electrode, and covered with the via layer.

One or more embodiments of the present disclosure are directed towards a display device, including: sub-pixels formed on a substrate arranged on a plane defined based on a first direction and a second direction normal (e.g., perpendicular) to the first direction, and including a first sub-pixel including a first emission area, a second sub-pixel including a second emission area, and a third sub-pixel including a third emission area. Each of the sub-pixels may include: a light emitting element including an anode electrode, a cathode electrode, and an emission structure electrically connected between the anode electrode and the cathode electrode; a pixel circuit electrically connected to the light emitting element; and a data line electrically connected to the pixel circuit. The emission structure may be arranged over the sub-pixels, and at least a portion of the emission structure may be disconnected by a trench formed in a boundary area between the sub-pixels. The trench may include a first trench formed around the first emission area, a second trench formed around the second emission area, and a third trench formed around the third emission area, and may be spaced and/or apart (e.g., spaced apart or separated) from the data line on the plane. The second emission area and the third emission area may be adjacent to each other in the first direction, and a boundary area between the second emission area and the third emission area may overlap the first emission area in the second direction. The data line may be in a form of a single line in each of an area between the trench and the second trench and an area between the first trench and the third trench. The data line may be in a form of a plurality of lines in an area between the second trench and the third trench.

One or more embodiments of the present disclosure, an electronic device may comprise a processor configured to provide input image data; a display device configured to display an image based on the input image data, the display device including sub-pixel areas; and a power supply configured to supply power to the display device. The display device may comprise: a pixel circuit layer comprising a substrate on a plane, a pixel circuit on the substrate, a data line electrically connected to the pixel circuit, and a via layer covering the pixel circuit and the data line; a light emitting element on the pixel circuit layer, and comprising an anode electrode, a cathode electrode, and an emission structure electrically connected between the anode electrode and the cathode electrode; and a pixel defining layer on the pixel circuit layer, and covering a portion of the anode electrode. A trench passing both through the pixel defining layer and through a portion of the via layer may be in an area adjacent to the anode electrode. The trench may be between the anode electrode and the data line in a plan view of the display device.

At least some of the above and other features of the invention are set out in the claims.

### BRIEF DESCRIPTION OF THE DRAWINGS

FIG. 1 is a schematic plan view illustrating a display device in accordance with one or more embodiments.
FIG. 2 is a circuit diagram illustrating a sub-pixel including a pixel circuit in accordance with one or more embodiments.
FIG. 3 is a schematic exploded perspective view illustrating a display device in accordance with one or more embodiments.
FIGS. 4 and 5 are schematic plan views each illustrating a display device in accordance with one or more embodiments.
FIGS. 6 and 9 are schematic sectional views each illustrating a display device in accordance with one or more embodiments.
FIGS. 7 and 8 are schematic sectional views each illustrating a light emitting element in accordance with one or more embodiments.
FIG. 10 is a block diagram illustrating one or more embodiments of a electronic device.
FIG. 11 is a perspective diagram illustrating an application example of the electronic device of FIG. 10.
FIG. 12 is a diagram illustrating a head-mounted display device of FIG. 11 that is worn on a head of a user.

### DETAILED DESCRIPTION

As the present disclosure allows for one or more suitable changes and numerous embodiments, particular embodiments will be illustrated in the drawings and described in more detail in the written description. However, this is not intended to limit the present disclosure to particular modes of practice, and it is to be appreciated that all changes, equivalents, and substitutes that do not depart from the technical scope of the present disclosure, as defined in the claims, are encompassed in the present disclosure.

It will be understood that, although the terms "first", "second", and/or the like. may be utilized herein to describe one or more suitable elements, these elements should not be limited by these terms. These terms are only utilized to distinguish one element from another element. For instance, a first element discussed could be termed a second element without departing from the teachings of the present disclosure. Similarly, the second element could also be termed the first element. In the present disclosure, the singular forms are intended to include the plural forms as well, unless the context clearly indicates otherwise.

It will be further understood that the terms "comprise", "include", "have", and/or the like if (e.g., when) utilized in the present disclosure, specify the presence of stated features, integers, steps, operations, elements, components, and/and/or one or more (e.g., any suitable) combinations of them but do not preclude the presence or addition of one or more other features, integers, steps, operations, elements, components, and/and/or one or more (e.g., any suitable) combinations thereof. Furthermore, in case that a first part such as a layer, a film, a region, or a plate is arranged on a second part, the first part may be not only directly on the second part but a third part may intervene between them. In addition, if (e.g., when) it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them. In contrast, when an element or layer is referred to as being "directly on," "directly connected to", "directly coupled to", or "immediately adjacent to" another element or layer, there are no intervening elements or layers present.

One or more embodiments of the present disclosure relate to a display device and an electronic device comprising the display device. Hereinafter, a display device and an electronic device comprising the display device in accordance with one or more embodiments will be described with reference to the attached drawings.

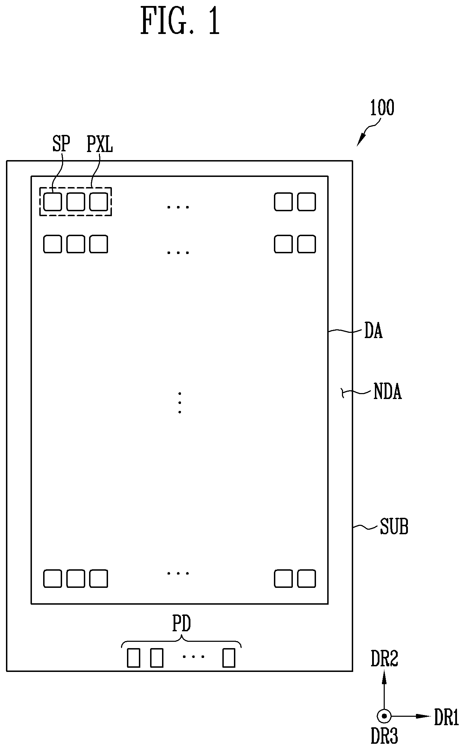

FIG. 1 is a schematic plan view illustrating a display device 100 in accordance with one or more embodiments.

Referring to FIG. 1, the display device 100 in accordance with one or more embodiments is to emit light.

The display device 100 may include a display area DA and a non-display area NDA. The display device 100 may display an image through the display area DA. The non-display area NDA may be arranged around the display area DA.

The display device 100 may include a substrate SUB, sub-pixels SP, and pads PD.

The display device 100 may be applied to one or more suitable fields. For example, the display device 100 may be utilized as a display screen of a device, such as a head-mounted display (HMD) device, a virtual reality (VR) device, a mixed reality (MR) device, and/or an augmented reality (AR) device. In some embodiments, the display device 100 may be positioned very close to the eyes of a user (e.g., a distance of about 2 cm to about 5 cm from the user's eyes). In some embodiments, relatively high-density sub-pixels SP may be desired or required (e.g., the display device 100 may be positioned very close to the user's eyes, requiring relatively high-density sub-pixels (SP)). To increase the pixel density of the sub-pixels SP, the substrate SUB may be provided utilizing a silicon substrate. The sub-pixels SP and/or the display device 100 may be formed on the substrate SUB, which is a silicon substrate. The display device 100 fabricated based on the substrate SUB that is in a form of a silicon substrate may be referred to as an OLED on Silicon (OLEDoS) display device.

The substrate SUB may be arranged on a plane defined by a first direction DR1 and a second direction DR2. The substrate SUB may be arranged on a plane extending in a first direction DR1 and a second direction DR2. It will be understood that these directions, direction DR3 perpendicular thereto, and directions discussed in relation to other figures, are example directions expressed relative to the device and do not imply any particular orientation of the device.

The sub-pixels SP may be arranged in the display area DA on the substrate SUB. The sub-pixels SP may be arranged in one or more suitable arrangement structures. For example, the sub-pixels SP may be arranged in the form of a matrix along the first direction DR1 and the second direction DR2 different from the first direction DR1. The first direction DR1 and the second direction DR2 may intersect with each other, and may be normal (e.g., perpendicular) to each other. The first direction DR1 may refer to a row direction, and the second direction DR2 may refer to a column direction. In one or more embodiments, the sub-pixels SP may be arranged in a zigzag pattern in the first direction DR1 and the second direction DR2. For example, the sub-pixels SP may be arranged in the form of PENTILE^{®} (e.g., a PENTILE^{®} arrangement structure), for example, an RGBG matrix, RGBG structure, or RGBG matrix structure, but the present disclosure is not limited thereto. PENTILE^{®} is a duly registered trademark of Samsung Display Co., Ltd.).

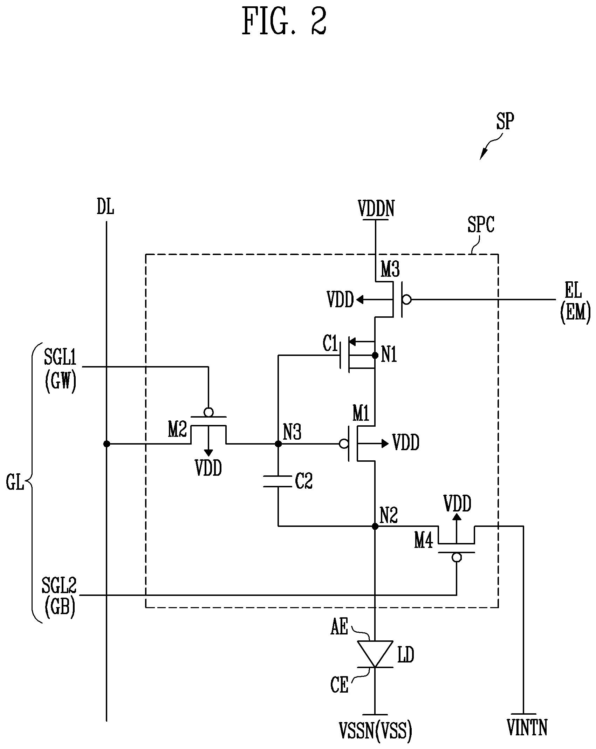

Each of the sub-pixels SP may include at least one light emitting element LD (refer to FIG. 2) to generate light. Accordingly, each of the sub-pixels SP may generate light in a specific color, such as red, green, blue, cyan, magenta, or yellow. Two or more sub-pixels SP among the sub-pixels SP may form a pixel PXL. For example, as illustrated in FIG. 1, three sub-pixels SP may form a pixel PXL.

Hereinafter, descriptions will be provided based on one or more embodiments where the sub-pixels SP include a first sub-pixel SP1 to provide light of a first color (e.g., red), a second sub-pixel SP2 to provide light of a second color (e.g., green), and a third sub-pixel SP3 to provide light of a third color (e.g., blue).

In one or more embodiments, the first sub-pixel SP1 may provide light in a wavelength band in a range of 600 nm to 750 nm as a red sub-pixel. The second sub-pixel SP2 may provide light in a wavelength band in a range of 480 nm to 560 nm as a green sub-pixel. The third sub-pixel SP3 may provide light in a wavelength band in a range of 370 nm to 460 nm as a blue sub-pixel.

Components for controlling the sub-pixels SP may be arranged in the non-display area NDA on the substrate SUB. For example, lines connected to the sub-pixels SP (e.g., gate lines and data lines for driving the sub-pixels SP) may be arranged in the non-display area NDA. Furthermore, a gate driver, a data driver, a voltage generator, a controller, a temperature sensor, and/or the like may be integrated in the non-display area NDA of the display device 100 to acquire driving signals to be supplied to the sub-pixels SP. However, the present disclosure is not limited to the aforementioned example.

The pads PD may be arranged in the non-display area NDA on the substrate SUB. The pads PD may be electrically connected to the sub-pixels SP through the lines. For example, the pads PD may be connected (e.g., electrically connected) to the sub-pixels SP through the data lines.

The pads PD may interface the components in the display area DA and the non-display area NDA with other components of the display device 100. In one or more embodiments, voltages and signals desired or required for the operation of the components included in the display device 100 may be provided from a driver integrated circuit through the pads PD. For example, the data lines may be electrically connected to the driver integrated circuit through the pads PD. For example, the power voltages for driving the sub-pixels SP may be received from the driver integrated circuit through the pads PD. For example, a gate control signal for controlling the gate driver may be transmitted from the driver integrated circuit to the gate driver through the pads PD.

In one or more embodiments, a circuit board may be electrically connected to the pads PD by a conductive adhesive component, such as an anisotropic conductive film. Here, the circuit board may be a flexible circuit board or flexible film that is made of flexible material. The driver integrated circuit may be arranged on (e.g., mounted on) the circuit board and be electrically connected to the pads PD.

FIG. 2 is a circuit diagram illustrating a sub-pixel SP including a pixel circuit SPC in accordance with one or more embodiments. FIG. 2 is a circuit diagram schematically illustrating the pixel circuit SPC for driving the sub-pixel SP in accordance with one or more embodiments.

Referring to FIG. 2, the sub-pixel SP may include the pixel circuit SPC and a light emitting element LD. The sub-pixel circuit SPC may include a first transistor M1, a second transistor M2, a third transistor M3, a fourth transistor M4, a first capacitor C1, and a second capacitor C2. The display device 100 may include a data line DL, a gate line GL, and an emission control line EL that are electrically connected to the pixel circuit SPC.

The light emitting element LD may be electrically connected between a first power voltage node VDDN and a second power voltage node VSSN. The first power voltage node VDDN may be a node provided to transmit a first power voltage VDD. The second power voltage node VSSN may be a node provided to transmit a second power voltage VSS. The first power voltage VDD may be a high-potential voltage, and the second power voltage VSS may be a low-potential voltage.

The light emitting element LD may include an anode electrode AE and a cathode electrode CE.

The anode electrode AE may be electrically connected to the first power voltage node VDDN through the pixel circuit SPC. For example, the anode electrode AE may be electrically connected to the first power voltage node VDDN via a second node N2, the first transistor M1, a first node N1, and the third transistor M3. The cathode electrode CE may be electrically connected to the second power voltage node VSSN. The light emitting element LD may generate light of a certain luminance corresponding to the amount of current that is supplied from the first power voltage node VDDN to the second power voltage node VSSN via the pixel circuit SPC.

The pixel circuit SPC may be electrically connected to the data line DL, the gate line GL, and the emission control line EL. The pixel circuit SPC may be to control the light emitting element LD based on signals supplied from the data line DL, the gate line GL, and the emission control line EL.

The pixel circuit SPC may operate in response to a scan signal received through the gate line GL. The gate line GL may include one or more sub-gate lines. For example, the gate line GL may include a first sub-gate line SGL1 and a second sub-gate line SGL2.

The pixel circuit SPC may operate in response to an emission control signal received through the emission control line EL.

The pixel circuit SPC may receive a data signal through the data line DL. The pixel circuit SPC may store a voltage corresponding to the data signal in response to at least one of scan signals received through the first and second sub-gate lines SGL1 and SGL2. The pixel circuit SPC may adjust current flowing from the first power voltage node VDDN to the second power voltage node VSSN through the light emitting element LD according to the stored voltage, in response to the emission control signal received through the emission control line EL. Therefore, the light emitting element LD may be to emit light with a luminance corresponding to the data signal.

Each of the first to fourth transistors M1 to M4 may be a metal oxide semiconductor field effect transistor (MOSFET) including a body electrode. In some embodiments, the first to fourth transistors M1 to M4 may be arranged (e.g., mounted) in a relatively small area, thus allowing the pixel PXL (see FIG. 1) to be applied to a high-resolution panel. The body electrode of each of the first to fourth transistors M1 to M4 may be supplied with the first power voltage VDD. In one or more embodiments, each of the first to fourth transistors M1 to M4 may be in a form of a P-type (kind) transistor. However, the aforementioned example is illustrative, and at least one of the first to fourth transistors M1 to M4 may be substituted with an N-type (kind) transistor.

The first transistor M1 may include a first electrode connected to the first node N1, and a second electrode connected to the second node N2. Here, the term "connected" implies being electrically linked or joined. A gate electrode of the first transistor M1 may be connected to a third node N3. The first node N1 may refer to a node to which a second electrode of the third transistor M3 is connected. The second node N2 may refer to a node to which the anode electrode AE of the light emitting element LD is connected. The first transistor M1 may control, in response to the voltage of the third node N3, the amount of current to be supplied from the first power voltage node VDDN to the second power voltage node VSSN via the light emitting element LD.

The second transistor M2 may be connected between the data line DL and the third node N3. A gate electrode of the second transistor M2 may be electrically connected to the first sub-gate line SGL1. If (e.g., when) a first scan signal GW is supplied to the first sub-gate line SGL1, the second transistor M2 may be turned on to electrically connect the data line DL to the third node N3.

A first electrode of the third transistor M3 may be electrically connected to the first power voltage node VDDN, and the second electrode thereof may be connected to the first node N1. A gate electrode of the third transistor M3 may be electrically connected to the emission control line EL. The third transistor M3 may be turned off if (e.g., when) the emission control signal EM (or a disable emission control signal) is supplied to the emission control line EL, and may be turned on if (e.g., when) no emission control signal EM is supplied to the emission control line EL (or if (e.g., when) an enable emission control signal EM is supplied thereto). If the third transistor M3 is turned off, the first power voltage node VDDN and the first node N1 may be electrically disconnected.

The fourth transistor M4 may include a first electrode connected to the second node N2, and a second electrode electrically connected to the initialization voltage node VINTN. The initialization voltage node VINTN is to transmit an initialization voltage. The initialization voltage may be provided by the voltage generator. The initialization voltage may be set to a voltage that turns off the light emitting element LD if (e.g., when) supplied to the anode electrode AE of the light emitting element LD. If (e.g., when) a second scan signal GB is supplied to the second sub-gate line SGL2, the fourth transistor M4 may be turned on to electrically connect the second node N2 with the initialization voltage node VINTN.

The first capacitor C1 may be connected between the first node N1 and the third node N3. The first capacitor C1 may be in a form of a metal-oxide-semiconductor (MOS) capacitor. The first capacitor C1 may be driven as a coupling capacitor, thus transmitting variance in voltage of the first node N1 to the third node N3. Furthermore, the first capacitor C1 may store the voltage of the third node N3.

The second capacitor C2 may include a first electrode connected to the third node N3, and a second electrode connected to the second node N2. The second capacitor C2 may be in a form of a different type or kind of capacitor from the first capacitor C1. For example, the second capacitor C2 may be in a form of a metal-oxide-metal (MOM) capacitor. The second capacitor C2 may be driven as a coupling capacitor, thus transmitting variance in voltage of the second node N2 to the third node N3. The second capacitor C2 may have a lower capacity compared to that of the first capacitor C1.

However, the structure of the sub-pixel SP according to the present disclosure is not limited to the aforementioned example.

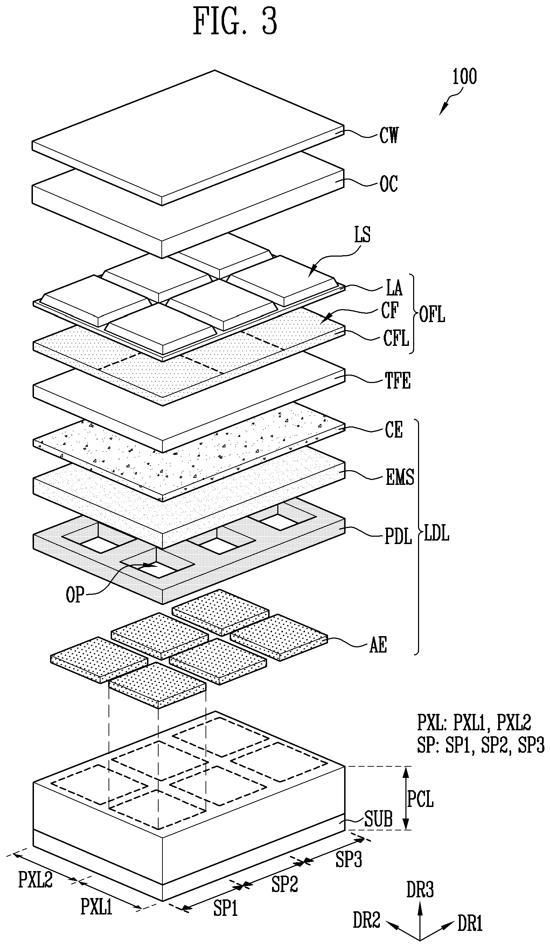

FIG. 3 is a schematic exploded perspective view illustrating a display device 100 in accordance with one or more embodiments. In FIG. 3, for a clear and concise explanation, there is schematically illustrated a portion of the display device 100 corresponding to two pixels PXL1 and PXL2 among the pixels PXL. The remaining portions of the display device 100 corresponding to the other pixels may also be configured in substantially the same manner.

Referring to FIG. 3, each of the first and second pixels PXL1 and PXL2 may include first to third sub-pixels SP1 to SP3. However, one or more embodiments are not limited to the aforementioned example. For example, each of the first and second pixels PXL1 and PXL2 may include four sub-pixels, or may include two sub-pixels.

In FIG. 2, there is illustrated an example in which the first to third sub-pixels SP1 to SP3 have rectangular shapes and the same size if (e.g., when) viewed in a third direction DR3 crossing (e.g., intersecting) with the first and second directions DR1 and DR2. However, one or more embodiments are not limited to the aforementioned example. The first to third sub-pixels SP1 to SP3 may be modified to have one or more suitable planar shapes.

The display device 100 may include a substrate SUB, a pixel circuit layer PCL, a light-emitting-element layer LDL, an encapsulation layer TFE, an optical functional layer OFL, an overcoat layer OC, and a cover window CW.

In one or more embodiments, the substrate SUB may include a silicon wafer substrate formed through a semiconductor process. The substrate SUB may include semiconductor material suitable for forming circuit elements. For example, the semiconductor material may include silicon, germanium, and/or silicon-germanium. The substrate SUB may be provided from a bulk wafer, an epitaxial layer, a silicon on insulator (SOI) layer, a semiconductor on insulator (SeOI) layer, and/or the like. In one or more embodiments, the substrate SUB may include a glass substrate. In one or more embodiments, the substrate SUB may include a polyimide substrate.

The pixel circuit layer PCL may be arranged on the substrate SUB. The substrate SUB and/or the pixel circuit layer PCL may include insulating layers, and conductive patterns arranged between the insulating layers. The conductive patterns of the pixel circuit layer PCL may function as at least some of the circuit components, lines, and/or the like. The conductive patterns may include one or more suitable conductive materials. The embodiments are not limited to a specific example. The circuit elements may include respective pixel circuits SPC of the first to third sub-pixels SP1 to SP3. The pixel circuit SPC may include transistors and one or more capacitors.

The light-emitting-element layer LDL may include anode electrodes AE, a pixel defining layer PDL, an emission structure EMS, and a cathode electrode CE.

The anode electrodes AE may be arranged on the pixel circuit layer PCL. The anode electrodes AE may be electrically connected to circuit elements of the pixel circuit layer PCL.

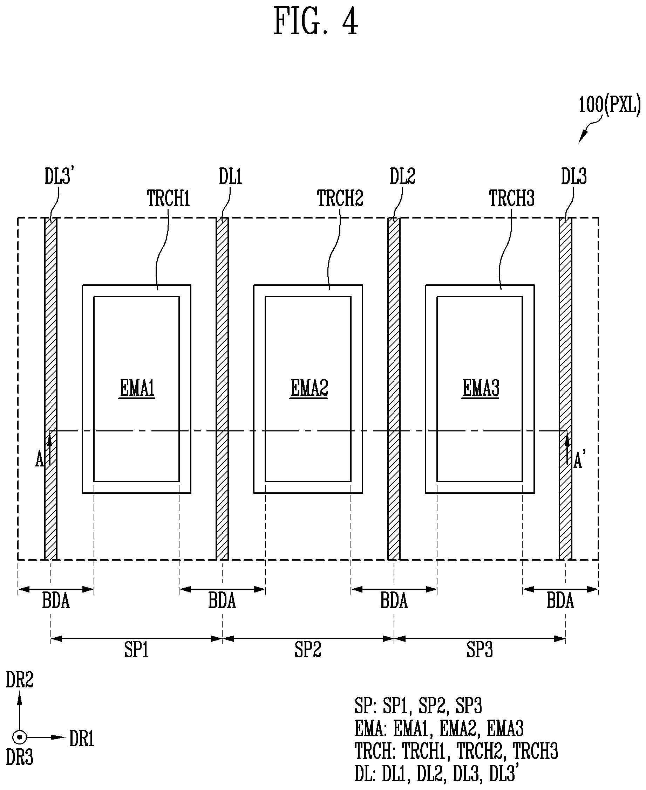

The pixel defining layer PDL may be arranged on the anode electrodes AE. The pixel defining layer PDL may include openings OP that expose respective portions of the anode electrodes AE. The openings OP in the pixel defining layer PDL may be understood as respective emission areas EMA1 to EMA3 (refer to FIG. 4) corresponding to the first to third sub-pixels SP1 to SP3.

In one or more embodiments, the pixel defining layer PDL may include inorganic material. In some embodiments, the pixel defining layer PDL may include a plurality of inorganic layers stacked on top of one another. For example, the pixel defining layer PDL may include silicon oxide (SiOₓ) and/or silicon nitride (SiNₓ). In one or more embodiments, the pixel defining layer PDL may include organic material. However, the material of the pixel defining layer PDL is not limited to the aforementioned examples.

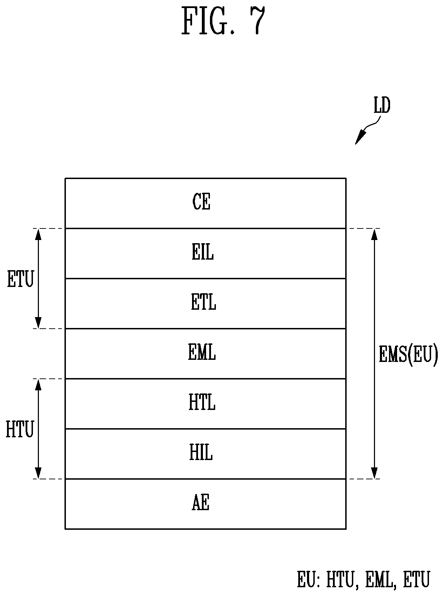

The emission structure EMS may be arranged on the anode electrodes AE exposed through the openings OP in the pixel defining layer PDL. The emission structure EMS may include an emission layer EML (refer to FIG. 7) to generate light, an electron transport component ETU (refer to FIG. 7) to transport electrons, and a hole transport component HTU (refer to FIG. 7) to transport holes.

In one or more embodiments, the emission structure EMS may fill the openings OP in the pixel defining layer PDL and be arranged on an overall surface of an upper portion of the pixel defining layer PDL. For example, the emission structure EMS may be extended (e.g., arranged) over the first to third sub-pixels SP1 to SP3. In some embodiments, at least a part of the layers in the emission structure EMS may be disconnected or bent at boundaries between the first to third sub-pixels SP1 to SP3.

The cathode electrode CE may be arranged on the emission structure EMS. The cathode electrode CE may be extended over the first to third sub-pixels SP1 to SP3. As such, the cathode electrode CE may be provided as a common electrode for the first to third sub-pixels SP1 to SP3.

The cathode electrode CE may be a thin-film metal layer having a thickness allowing light emitted from the emission structure EMS to pass therethrough.

The cathode electrode CE may be to supply a cathode voltage to the emission structure EMS.

In one or more embodiments, the cathode electrode CE may be made of a metal material having a relatively small thickness, and/or a transparent conductive material. In one or more embodiments, the cathode electrode CE may include at least one of suitable transparent conductive materials including indium tin oxide (ITO), indium zinc oxide (IZO), indium gallium zinc oxide (IGZO), aluminum zinc oxide (AZO), indium tin zinc oxide (ITZO), zinc oxide (ZnO), and/or tin oxide (SnO₂). In one or more embodiments, the cathode electrode CE may include at least one of silver (Ag), magnesium (Mg), and/or a compound thereof. However, the material of the cathode electrode CE is not limited to the foregoing example.

Any one of the anode electrodes AE, a portion of the emission structure EMS that overlap the any one of the anode electrodes AE, and a portion of the cathode electrode CE that overlaps the portion of the emission structure EMS may be understood as constituting one light emitting element LD. For example, each of the light emitting elements of the first to third sub-pixels SP1 to SP3 may include an anode electrode AE, a portion of the emission structure EMS that overlaps the an anode electrode AE, and a portion of the cathode electrode CE that overlaps the portion of the emission structure EMS. In each of the first to third sub-pixels SP1 to SP3, holes injected from the anode electrode AE and electrons injected from the cathode electrode CE are transported into the emission layer EML of the emission structure EMS, thus forming excitons. If (e.g., when) the excitons make a transition (relax) from an excited state to a ground state, light may be generated. The luminance of light may be determined based on the amount of current flowing through the emission layer EML. Depending on the configuration of the emission layer EML, the wavelength range of the generated light may be determined.

The encapsulation layer TFE may be arranged on the cathode electrode CE. The encapsulation layer TFE may cover the light-emitting-element layer LDL and the pixel circuit layer PCL. The encapsulation layer TFE may be to prevent or reduce oxygen and/or water and/or the like from penetrating into the light-emitting-element layer LDL. In one or more embodiments, the encapsulation layer TFE may include a structure formed by alternately stacking one or more inorganic layers and one or more organic layers. For example, the inorganic layer may include silicon nitride, silicon oxide, silicon oxynitride (SiOₓN_{y}), and/or the like. For example, the organic layer may include organic insulating material, such as acrylic resin, epoxy resin, phenol resin, polyamide resin, polyimide resin, unsaturated polyester resin, polyphenylenether resin, polyphenylenesulfide resin, and/or benzocyclobutene (BCB). However, the materials of the organic layer and the inorganic layer of the encapsulation layer TFE are not limited to the aforementioned examples.

The optical functional layer OFL may be arranged on the encapsulation layer TFE. The optical functional layer OFL may include a color filter layer CFL and a lens array LA.

The color filter layer CFL may be arranged between the encapsulation layer TFE and the lens array LA. The color filter layer CFL may be to filter light emitted from the emission structure EMS to selectively output light in a wavelength range and/or color corresponding to each sub-pixel. The color filter layer CFL may include color filters CF respectively corresponding to the first to third sub-pixels SP1 to SP3. Each of the color filters CF allows light within a wavelength range corresponding to the related sub-pixel to pass therethrough. For example, the color filter that corresponds to the first sub-pixel SP1 allows light in a red color to pass therethrough, the color filter that corresponds to the second sub-pixel SP2 allows light in a green color to pass therethrough, and the color filter that corresponds to the third sub-pixel SP3 allows light in a blue color to pass therethrough. Depending on the light emitted from the emission structure EMS of each sub-pixel, at least some of the color filters CF may not be provided.

The lens array LA may be arranged on the color filter layer CFL. The lens array LA may include lenses LS that respectively correspond to the first to third sub-pixels SP1 to SP3. Each of the lenses LS may output and direct light emitted from the emission structure EMS along an intended path, thus enhancing the light output efficiency. The lens array LA may have a relatively high refractive index. For example, the lens array LA may have a higher refractive index than the overcoat layer OC. In one or more embodiments, the lenses LS may include organic material. In one or more embodiments, the lenses LS may include acrylic material. However, the material of the lenses LS is not limited to the foregoing example.

The plane defined in this specification may be extended in the first direction DR1 and the second direction DR2, and may be defined based on the plane on which the substrate SUB is arranged. In one or more embodiments, the third direction DR3 may correspond to the thickness direction of the substrate SUB. The third direction DR3 may correspond to a light output direction of the display device 100.

The overcoat layer OC may be arranged on the lens array LA. The overcoat layer OC may cover the optical functional layer OFL, the encapsulation layer TFE, the emission structure EMS, and/or the pixel circuit layer PCL. The overcoat layer OC may include one or more suitable materials suitable for protecting underlying layers from foreign substances, such as dust, water, and/or the like. For example, the overcoat layer OC may include at least one of an inorganic insulating layer and/or an organic insulating layer. For example, the overcoat layer OC may include epoxy resin, but it is not limited thereto. The overcoat layer OC may have a lower refractive index than the lens array LA.

The cover window CW may be arranged on the overcoat layer OC. The cover window CW may be to protect underlying layers. The cover window CW may have a higher refractive index than the overcoat layer OC. The cover window CW may include glass, but embodiments are not limited thereto. For example, the cover window CW may be an encapsulation glass layer to protect components arranged thereunder. In one or more embodiments, the cover window CW may not be provided.

A display device 100 including a data line DL and a trench TRCH in accordance with one or more embodiments will be described with reference to FIGS. 4 to 9. Description overlapping with the details mentioned above will be simplified, or may not be repeated.

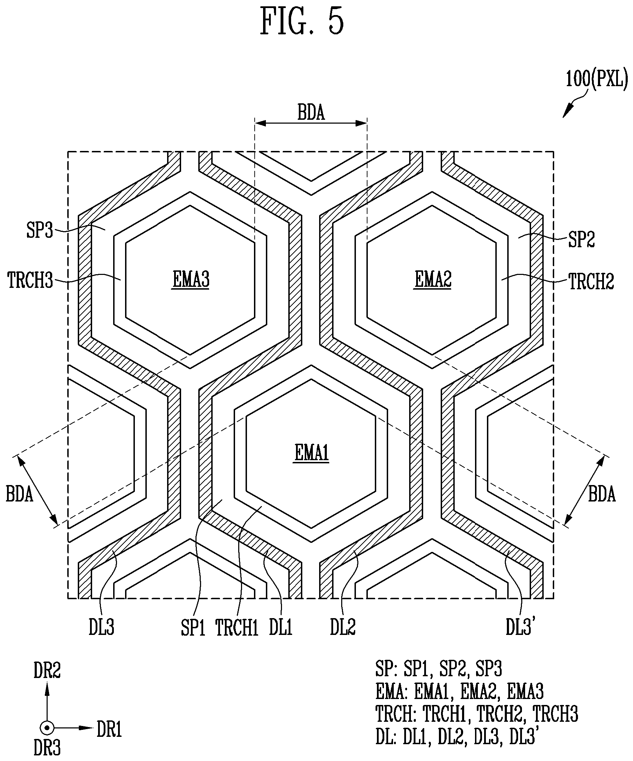

First, a planar structure of the display device 100 in accordance with one or more embodiments will be described with reference to FIGS. 4 and 5.

FIGS. 4 and 5 are schematic plan views each illustrating a display device 100 in accordance with one or more embodiments. FIGS. 4 and 5 each schematically illustrate a pixel PXL in accordance with one or more embodiments.

Referring to FIGS. 4 and 5, each of the sub-pixels SP may include an emission area EMA. The sub-pixels SP may include first to third sub-pixels SP1 to SP3. The emission areas EMA may include a first emission area EMA1 that forms (e.g., corresponds to) the first sub-pixel SP1, a second emission area EMA2 that forms (e.g., corresponds to) the second sub-pixel SP2, and a third emission area EMA3 that forms (e.g., corresponds to) the third sub-pixel SP3.

The first emission area EMA1 may be included in the first sub-pixel SP1, and may be an area where light emitted from the light emitting element LD included in the first sub-pixel SP1 is provided. The second emission area EMA2 may be included in the second sub-pixel SP2, and may be an area where light emitted from the light emitting element LD included in the second sub-pixel SP2 is provided. The third emission area EMA3 may be included in the third sub-pixel SP3, and may be an area where light emitted from the light emitting element LD included in the third sub-pixel SP3 is provided.

In one or more embodiments (refer to FIG. 4), the first to third emission areas EMA1 to EMA3 that form a pixel PXL may be adjacent to each other in the first direction DR1.

In one or more embodiments (refer to FIG. 5), a part of the emission areas EMA that form a pixel PXL may be adjacent to each other in the first direction DR1, and the other part of the emission areas EMA may be adjacent to each other in a diagonal direction. For example, the first emission area EMA1 may be adjacent to each of the second emission area EMA2 and the third emission area EMA3 in a diagonal direction. The second emission area EMA2 and the third emission area EMA3 may be adjacent to each other in the first direction DR1, and a boundary area BDA between the second emission area EMA2 and the third emission area EMA3 may overlap the first emission area EMA1 in the second direction DR2

The display device 100 may include a trench TRCH formed around the emission area EMA.

The trench TRCH may be a structure capable of disconnecting at least a portion of the emission structure EMS arranged across the sub-pixels SP.

The trench TRCH may completely or substantially enclose the emission area EMA. For example, the trench TRCH may enclose the entire emission area EMA in a plan view, as depicted in Figures 4 and 5.

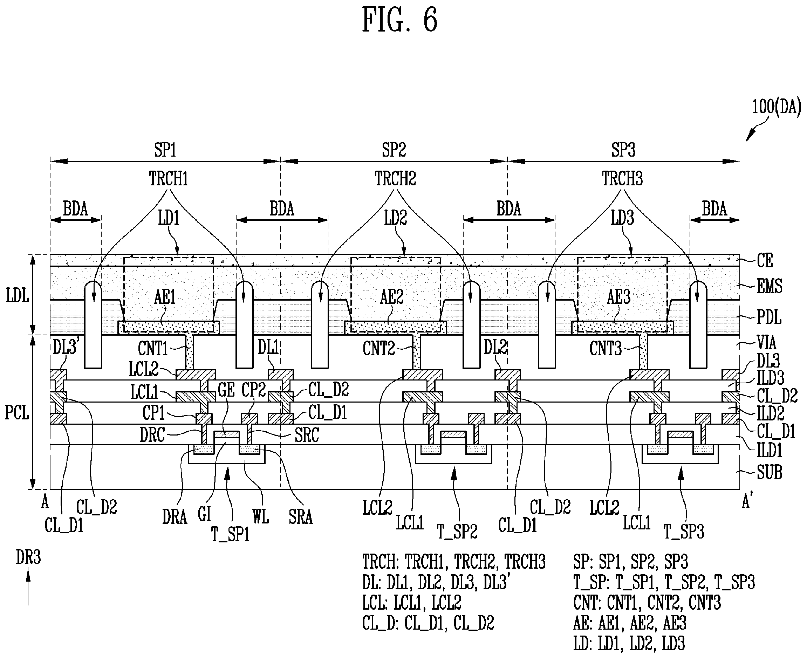

The trench TRCH may have a shape corresponding to that of the emission area EMA. For example (refer to FIG. 4), in some embodiments, if (e.g., when) the emission area EMA has an approximately (substantially) rectangular shape, the trench TRCH may have a substantially rectangular shape. In another example (refer to FIG. 5), in some embodiments, if (e.g., when) the emission area EMA has an approximately hexagonal shape, the trench TRCH may have a substantially hexagonal shape. In other words (refer to FIG. 6), the display device 100 may include a pixel circuit layer PCL with a substrate SUB, a pixel circuit SPC, a data line DL, and a via layer VIA. A light-emitting element LD with an anode electrode AE, cathode electrode CE, and emission structure EMS is placed on this layer, partially covered by a pixel defining layer PDL. A trench TRCH is formed through both the pixel defining layer PDL and a via layer VIA, positioned between the anode electrode AE and data line DL. The emission areas EMA1 to EMA3 of a pixel PXL can be adjacent in the first direction DR1 or in the diagonal direction. The trench TRCH surrounds the emission area EMA, disconnecting parts of the emission structure EMS across sub-pixels SP, and its shape matches the emission area EMA, whether rectangular or hexagonal.

The trench TRCH may include a first trench TRCH1 that encloses the entire first emission area EMA1, a second trench TRCH2 that encloses the entire second emission area EMA2, and a third trench TRCH3 that encloses the entire third emission area EMA3. In other words, the trench TRCH may be in a form of three separate trenches: a first trench TRCH1 enclosing the first emission area EMA1, a second trench TRCH2 enclosing the second emission area EMA2, and a third trench TRCH3 enclosing the third emission area EMA3. It will be understood that any number of trenches TRCHn may be provided, corresponding to the number of emission areas EMAn.

The data line DL may be patterned to correspond to each of the sub-pixels SP. For example, the data line DL may include a first data line DL1 that is electrically connected to the pixel circuit SPC of the first sub-pixel SP1 and is adjacent to the first emission area EMA1, a second data line DL2 that is electrically connected to the pixel circuit SPC of the second sub-pixel SP2 and is adjacent to the second emission area EMA2, and a third data line DL3 that is electrically connected to the pixel circuit SPC of the third sub-pixel SP3 and is adjacent to the third emission area EMA3. In one or more embodiments, the data line DL may further include a third adjacent data line DL3' corresponding to a third sub-pixel SP3 of another pixel adjacent to the pixel PXL.

The data line DL may be arranged in a boundary area BDA including an area between the sub-pixels SP adjacent to each other. In one or more embodiments, the boundary area BDA may include an area between the trenches TRCH adjacent to each other.

The data line DL may be spaced and/or apart (e.g., spaced apart or separated) from the trench TRCH in a plan view. The data line DL may be configured to not overlap the trench TRCH in a plan view. In other words, the data line DL may be arranged in the boundary area BDA between adjacent sub-pixels SP and trenches TRCH. The data line DL may be spaced from the trench TRCH and does not overlap with it in a plan view.

In one or more embodiments (refer to FIG. 4), the data line DL may be extended in a direction normal (e.g., perpendicular) to a direction in which the emission areas EMA corresponding to (for forming) a pixel PXL are spaced and/or apart (e.g., spaced apart or separated) from each other. For example, the first to third emission areas EMA1 to EMA3 may be spaced and/or apart (e.g., spaced apart or separated) from each other (e.g., adjacent to each other) in the first direction DR1. The data line DL may be extended in the second direction DR2.

The first data line DL1 may be arranged on a side of the first emission area EMA1, and may be arranged between the first emission area EMA1 and the second emission area EMA2. The first data line DL1 may be arranged between the first trench TRCH1 and the second trench TRCH2. The second data line DL2 may be arranged on a side of the second emission area EMA2, and may be arranged between the second emission area EMA2 and the third emission area EMA3. The second data line DL2 may be arranged between the second trench TRCH2 and the third trench TRCH3. The third data line DL3 may be arranged on a side of the third emission area EMA3, and may be arranged between the third emission area EMA3 and an adjacent pixel PXL. The third data line DL3 may be arranged between the third trench TRCH3 and an adjacent pixel PXL.

In one or more embodiments (refer to FIG. 5), the data line DL may be extended so as not to overlap the trench TRCH around the emission areas EMA. For example, the data line DL may be extended substantially parallel to a direction in which side portions of the adjacent emission areas EMA are extended. For example, a portion of the data line DL may be extended in the second direction DR2 in an area adjacent to side portions of the emission areas EMA that are extended in the second direction DR2. At least another portion of the data line DL may be extended in a diagonal direction in an area adjacent to side portions of the emission areas EMA that are extended in the diagonal direction different from the first direction DR1 or the second direction DR2.

At least a portion of the first data line DL1 may be extended in the second direction DR2. At least another portion of the first data line DL1 may be extended in a diagonal direction. At least a portion of the second data line DL2 may be extended in the second direction DR2. At least another portion of the second data line DL2 may be extended in a diagonal direction. At least a portion of the third data line DL3 may be extended in the second direction DR2. At least another portion of the third data line DL3 may be extended in a diagonal direction.

In this specification, the term "diagonal direction" may refer to a direction different from the first direction DR1 and the second direction DR2. The diagonal direction may be at least one of a first diagonal direction toward the lower right, a second diagonal direction toward the lower left, a third diagonal direction toward the upper left, and a fourth diagonal direction toward the upper right.

In one or more embodiments, the number of data lines DL formed between adjacent emission areas EMA may vary by areas.

For example, if (e.g., when) the data line DL is extended in the second direction DR2, the data line DL may be in a form of a plurality of lines in an area between the corresponding emission areas EMA. If (e.g., when) the data line DL is extended in a diagonal direction, the data line DL may be in a form of a single line in an area between the corresponding emission areas EMA. Accordingly, even if (e.g., when) each of the emission areas EMA has a polygonal shape (e.g., a hexagonal shape) having five or more sides, the data line DL may have an appropriate or suitable patterning structure.

The data line DL may be in a form of a single line in a boundary area BDA between the first trench TRCH1 and the second trench TRCH2. In one or more embodiments, in the boundary area BDA between the first trench TRCH1 and the second trench TRCH2, a portion of the second data line DL2 may be arranged without the first and third data lines DL1 and DL3 being placed therein.

The data line DL may be in a form of a single line in a boundary area BDA between the first trench TRCH1 and the third trench TRCH3. In one or more embodiments, in the boundary area BDA between the first trench TRCH1 and the third trench TRCH3, a portion of the first data line DL1 may be arranged without the second and third data lines DL2 and DL3 being placed therein.

The data line DL may be in a form of a plurality of lines in a boundary area BDA between the second trench TRCH2 and the third trench TRCH3. In one or more embodiments, in the boundary area BDA between the second trench TRCH2 and the third trench TRCH3, a portion of each of the first and second data lines DL1 and DL2 may be arranged without the third data line DL3 being placed therein. In other words, the data line DL may be formed as a single line or multiple lines in different boundary areas BDA. Specifically, between the first and second trenches TRCH1 and TRCH2, a portion of the second data line DL2 may be present without the first and third data lines DL1 and DL3. Similarly, between the first and third trenches TRCH1 and TRCH3, a portion of the first data line DL1 may be present without the second and third data lines DL2 and DL3. Additionally, between the second and third trenches TRCH2 and TRCH3, portions of the first and second data lines DL1 and DL2 may be present without the third data line DL3.

As described above, the data line DL and the trench TRCH may be spaced and/or apart (e.g., spaced apart or separated) from each other in a plan view. Hereinafter, a cross-sectional structure of the display device 100 in accordance with one or more embodiments related to the cross-sectional structure of the data line DL and the trench TRCH will be described with reference to FIGS. 6 to 9.

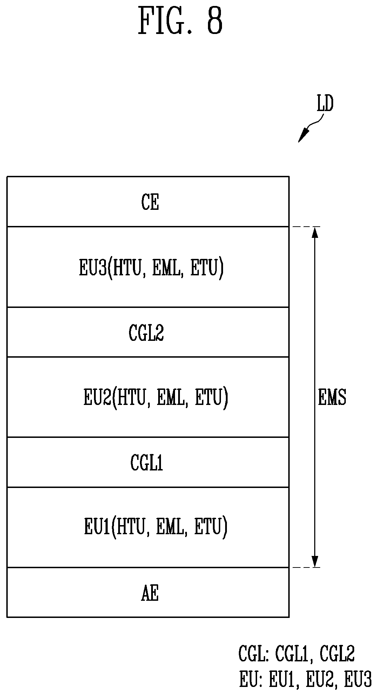

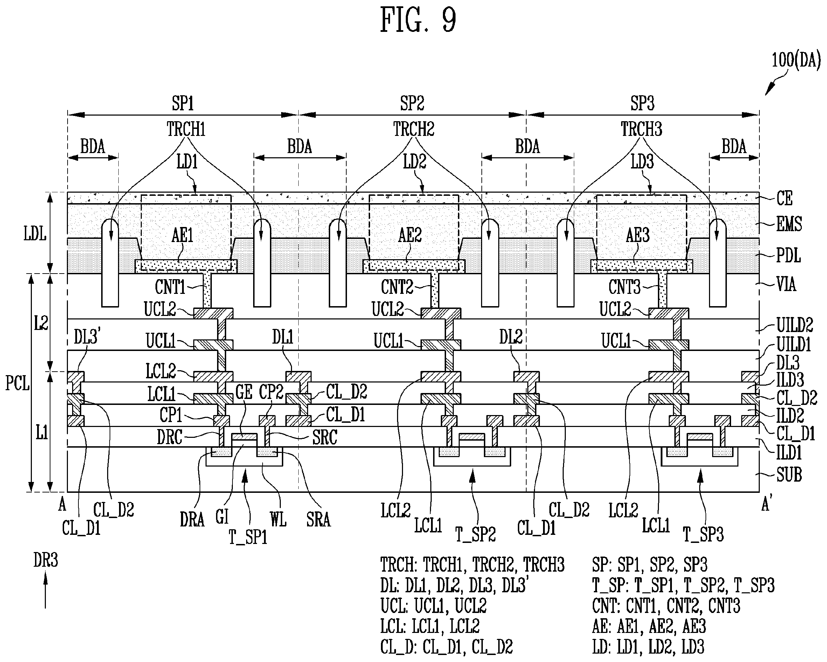

FIGS. 6 and 9 are schematic sectional views each illustrating a display device 100 in accordance with one or more embodiments. FIGS. 6 and 9 are schematic sectional views each taken along the line A-A' of FIG. 4. FIGS. 7 and 8 are schematic sectional views each illustrating a light emitting element LD in accordance with one or more embodiments.

First, the display device 100 in accordance with one or more embodiments will be described with reference to FIGS. 6 to 8.

Referring to FIGS. 6 to 8, the display device 100 may include a pixel circuit layer PCL and a light-emitting-element layer LDL on the pixel circuit layer PCL.

The pixel circuit layer PCL may include a substrate SUB, a pixel circuit SPC formed based on the substrate SUB, and lines electrically connected to the pixel circuit SPC. For example, the pixel circuit layer PCL may include the substrate SUB, an anode connection transistor T_SP, a first interlayer insulating layer ILD1, first and second conductive pattern layers CP1 and CP2, a data connection conductive layer CL_D, a second interlayer insulating layer ILD2, a lower conductive layer LCL, a third interlayer insulating layer ILD3, a data line DL, and a via layer VIA. The data connection conductive layer CL_D may include a first data connection conductive layer CL_D1 and a second data connection conductive layer CL_D2. The lower conductive layer LCL may include a first lower conductive layer LCL1 and a second lower conductive layer LCL2.

The pixel circuit SPC may be on (e.g., patterned on) the substrate SUB. The pixel circuit SPC may include an anode connection transistor T_SP. In FIG. 6, the anode connection transistor T_SP may be the fourth transistor M4 described with reference to FIG. 2. For convenience of description, other circuit elements that form the pixel circuit SPC are not depicted in FIG. 6.

In one or more embodiments, the light emitting element LD may include a first light emitting element LD1 that forms a first sub-pixel SP1, a second light emitting element LD2 that forms a second sub-pixel SP2, and a third light emitting element LD3 that forms a third sub-pixel SP3.

In one or more embodiments, the pixel circuit SPC may include a first pixel circuit included in the first sub-pixel SP1 and to drive the first light emitting element LD1, a second pixel circuit included in the second sub-pixel SP2 and to drive the second light emitting element LD2, and a third pixel circuit included in the third sub-pixel SP3 and to drive the third light emitting element LD3. Hence, the first pixel circuit may be electrically connected to the first data line DL1. The second pixel circuit may be electrically connected to the second data line DL2. The third pixel circuit may be electrically connected to the third data line DL3.

In one or more embodiments, the anode connection transistor T_SP may include a first anode connection transistor T_SP1 of the first sub-pixel SP1, a second anode connection transistor T_SP2 of the second sub-pixel SP2, and a third anode connection transistor T_SP3 of the third sub-pixel SP3.

Each of the anode connection transistors T_SP may include a source area SRA, a drain area DRA, and a gate electrode GE.

The source area SRA and the drain area DRA may be arranged in the substrate SUB. Formed through an ion injection process, a well WL may be arranged in the substrate SUB. The source area SRA and the drain area DRA may be arranged to be spaced and/or apart (e.g., spaced apart or separated) from each other in the well WL. An area between the source area SRA and the drain area DRA in the well WL may be defined as a channel area.

The gate electrode GE may overlap the channel area between the source area SRA and the drain area DRA, and may be arranged in the pixel circuit layer PCL. The gate electrode GE may be spaced and/or apart (e.g., spaced apart or separated) from the well WL and/or the channel area by an insulating material, such as a gate insulating layer GI. The gate electrode GE may include conductive material.

The first interlayer insulating layer ILD1 may cover the gate electrode GE and the gate insulating layer GI, and may be arranged on the substrate SUB. The first interlayer insulating layer ILD1 may include inorganic material, and may have a single-layer or multilayer structure.

The first and second conductive pattern layers CP1 and CP2 may be arranged on the first interlayer insulating layer ILD1. The first conductive pattern layer CP1 may be electrically connected to the drain area DRA through a drain connector DRC passing through the first interlayer insulating layer ILD1. The second conductive pattern layer CP2 may be electrically connected to the source area SRA through a source connector SRC passing through the first interlayer insulating layer ILD1.

Because the gate electrode GE and the first and second conductive pattern layers CP1 and CP2 are electrically connected to other circuit elements and/or lines, the anode connection transistor T_SP may form a structure for operating as the fourth transistor M4.

The first data connection conductive layer CL_D1 may be arranged on the first interlayer insulating layer ILD1. The first data connection conductive layer CL_D1 may be arranged in substantially the same layer as the first and second conductive pattern layers CP1 and CP2, and may include the same conductive material.

The first data connection conductive layer CL_D1 may be arranged to correspond to each of the first to third sub-pixels SP1 to SP3. The first data connection conductive layer CL_D1 may include a plurality of first data connection conductive layers CL_D1 that are respectively arranged in the boundary areas BDA. In one or more embodiments, the first data connection conductive layer CL_D1 may overlap one of the first to third data lines DL1 to DL3 in a plan view.

The second interlayer insulating layer ILD2 may cover the first and second conductive pattern layers CP1 and CP2 and the first data connection conductive layer CL_D1, and may be arranged on the first interlayer insulating layer ILD1. The second interlayer insulating layer ILD2 may include inorganic material, and may have a single-layer or multilayer structure.

The first lower conductive layer LCL1 may be arranged on the second interlayer insulating layer ILD2. The first lower conductive layer LCL1 may be electrically connected to the first conductive pattern layer CP1 (e.g., the anode connection transistor T_SP) through a contactor passing through the second interlayer insulating layer ILD2. The first lower conductive layer LCL1 may include conductive material.

The first lower conductive layer LCL1 may be arranged to correspond to each of the first to third sub-pixels SP1 to SP3. The first lower conductive layer LCL1 may include a plurality of first lower conductive layers LCL1 that are respectively arranged in the first to third sub-pixels SP1 to SP3. In one or more embodiments, the first lower conductive layer LCL1 may overlap one of the respective first conductive pattern layers CP1 of the first to third anode connection transistors T_SP1 to T_SP3.

The second data connection conductive layer CL_D2 may be arranged on the second interlayer insulating layer ILD2. The second data connection conductive layer CL_D2 may be arranged in substantially the same layer as the first lower conductive layer LCL1, and may include the same conductive material. The second data connection conductive layer CL_D2 may be electrically connected to the first data connection conductive layer CL_D1 through a contactor passing through the second interlayer insulating layer ILD2.

The second data connection conductive layer CL_D2 may be arranged to correspond to each of the first to third sub-pixels SP1 to SP3. The second data connection conductive layer CL_D2 may include a plurality of second data connection conductive layers CL_D2 arranged in each of the boundary areas BDA. In one or more embodiments, the second data connection conductive layer CL_D2 may overlap one of the first to third data lines DL1 to DL3 in a plan view.

The third interlayer insulating layer ILD3 may cover the first lower conductive layer LCL1 and the second data connection conductive layer CL_D2, and may be arranged on the second interlayer insulating layer ILD2. The third interlayer insulating layer ILD3 may include inorganic material, and may have a single-layer or multilayer structure.

The second lower conductive layer LCL2 may be arranged on the third interlayer insulating layer ILD3. The second lower conductive layer LCL2 may be electrically connected to the first lower conductive layer LCL1 through a contactor passing through the third interlayer insulating layer ILD3. The second lower conductive layer LCL2 may include conductive material.

The second lower conductive layer LCL2 may be arranged to correspond to each of the first to third sub-pixels SP1 to SP3. The second lower conductive layer LCL2 may include a plurality of second lower conductive layers LCL2 arranged in each of the first to third sub-pixels SP1 to SP3. In one or more embodiments, the second lower conductive layer LCL2 may overlap the first lower conductive layer LCL1 in a plan view.

The data line DL may be arranged on the third interlayer insulating layer ILD3. The data line DL may be arranged in substantially the same layer as the second lower conductive layer LCL2, and may include the same conductive material. The data line DL may be electrically connected to the second data connection conductive layer CL_D2 through a contactor passing through the third interlayer insulating layer ILD3.

The data line DL may be arranged to correspond to each of the first to third sub-pixels SP1 to SP3. The first data line DL1 may be arranged in the boundary area BDA that is adjacent to the first sub-pixel SP1. The second data line DL2 may be arranged in the boundary area BDA that is adjacent to the second sub-pixel SP2. The third data line DL3 may be arranged in the boundary area BDA that is adjacent to the third sub-pixel SP3.

The data line DL may overlap the first and second data connection conductive layers CL_D1 and CL_D2, in a plan view. A data signal supplied to the data line DL may be supplied to other circuit elements (e.g., the second transistor M2) through the data connection conductive layer CL_D. For example, in one or more embodiments, a data signal supplied through the data driver may be applied throughout the display area DA through the data line DL that is formed at a relatively upper side. At a position at which the sub-pixel SP is formed, a data signal supplied through the data line DL may be supplied to other circuit elements through the data connection conductive layers CL_D formed at a relatively lower side. That is, a data signal supplied through the data driver may be applied through the data line DL formed at an upper side of the sub-pixel SP, and a data signal supplied to other circuit elements may be applied through the data connection conductive layers CL_D formed at a lower side of the sub-pixel SP.

In one or more embodiments, the data line DL may be arranged at an upper side (e.g., the uppermost side) compared to other conductive structures that form the pixel circuit SPC. For example, no other conductive structure may be formed over the data line DL (e.g., between the data line DL and the pixel defining layer PDL). In some embodiments, the risk of distortion of a signal supplied to the data line DL by a conductive structure adjacent to the data line DL may be reduced, whereby the reliability of the data signal may be improved. Furthermore, the capacitance formed in the data line DL by other conductive structures may be reduced. In some embodiments, the power consumption desired or required to drive the light emitting elements LD may be reduced.

The via layer VIA may cover the second lower conductive layer LCL2 and the data lines DL (e.g., the pixel circuit SPC and the data line DL), and may be arranged on the third interlayer insulating layer ILD3. The via layer VIA may be an uppermost layer of the pixel circuit layer PCL, and may function as a planarization layer. The via layer VIA may include organic material. However, the present disclosure is not limited to the aforementioned example. In one or more embodiments, a portion of the trench TRCH may be formed in a portion of the via layer VIA.

The light-emitting-element layer LDL may include the anode electrode AE, the pixel defining layer PDL, the trench TRCH, the emission structure EMS, and the cathode electrode CE.

The anode electrode AE may be arranged on the pixel circuit layer PCL (e.g., the via layer VIA). In one or more embodiments, the anode electrode AE may include a first anode electrode AE1 of the first sub-pixel SP1, a second anode electrode AE2 of the second sub-pixel SP2, and/or a third anode electrode AE3 of the third sub-pixel SP3.

The anode electrode AE may be electrically connected to the anode connection transistor T_SP through two or more conductive layers (e.g., the lower conductive layer LCL). The first to third anode electrodes AE1 to AE3 may be electrically connected to the lower conductive layer LCL (e.g., the second lower conductive layer LCL2) through first to third contactors CNT1 to CNT3 passing through the via layer VIA. Hence, the anode electrode AE may be electrically connected to the anode connection transistor T_SP (e.g., the fourth transistor M4)

In one or more embodiments, the anode electrode AE may include at least one of transparent conductive materials, such as indium tin oxide (ITO), indium zinc oxide (IZO), zinc oxide (ZnOₓ), indium gallium zinc oxide (IGZO), and/or indium tin zinc oxide (ITZO). However, the material of the first to third anode electrodes AE1 to AE3 is not limited to the aforementioned example. For example, the first to third anode electrodes AE1 to AE3 may include titanium nitride.

The pixel defining layer PDL may cover at least a portion the anode electrode AE, and may be arranged on the pixel circuit layer PCL (e.g., the via layer VIA). In one or more embodiments, the pixel defining layer PDL may include one or more suitable sectional shapes. For example, the pixel defining layer PDL may include layers including different inorganic materials, and may have a stepped cross-sectional shape. At least a portion of the pixel defining layer PDL may be arranged in the boundary area BDA.

The trench TRCH may be arranged adjacent to the anode electrode AE, in a plan view. The trench TRCH may define the boundary area BDA, and may be arranged between adjacent anode electrodes AE. The trench TRCH may result in the formation of a discontinuity in the emission structure EMS in the boundary area BDA. For example, at least a portion of the emission structure EMS may be disconnected or bent in the boundary area BDA by the trench TRCH.

The trench TRCH may pass through the pixel defining layer PDL and, in one or more embodiments, partially pass through a portion of the via layer VIA.

The trench TRCH may include a void. The void formed by the trench TRCH may be filled with air. For example, an air layer in which the trench TRCH is defined may be enclosed by the pixel defining layer PDL, the emission structure EMS, and/or the via layer VIA.

Because the trench TRCH forms the void, at least a portion of the emission structure EMS formed to cover the trench TRCH may be disconnected or bent. For example, at least portions of the layers formed in common in the first to third sub-pixels SP1 to SP3 among a plurality of layers included in the emission structure EMS may be disconnected. For example, a portion of a charge generation layer CGL (refer to FIG. 8) and/or a hole transport component HTU included in the emission structure EMS may be disconnected by the trench TRCH.

The trench TRCH may be arranged between the anode electrode AE and the data line DL. For example, an imaginary line connecting the anode electrode AE and the data line DL may pass through the trench TRCH.

In one or more embodiments, because the trench TRCH includes an air layer, an air layer is arranged between the anode electrode AE and the data line DL. In some embodiments, the coupling capacitance between the anode electrode AE and the data line DL may be reduced. As the coupling capacitance decreases, interference between electrical signals may be reduced, and the reliability of the electrical signals for operating the light emitting element LD may be improved. In other words, the trench TRCH may include an air layer between the anode electrode AE and the data line DL. This air layer reduces the coupling capacitance between the anode electrode AE and the data line DL, which in turn decreases electrical signal interference and improves the reliability of the signals for operating the light-emitting element LD.

In one or more embodiments, as described above, the data line DL may be arranged at a relatively upper side, thereby providing technical effects such as power consumption reduction. For example, in one or more embodiments, in addition to implementing technical effects such as power consumption reduction, structural characteristics may be provided to mitigate the risks associated with the arrangement of the data line DL utilized to achieve the foregoing technical effects. As a result, according to the display device 100 in one or more embodiments, in addition to a reduction in power consumption desired or required when the sub-pixel SP is operated, technical effects of improving or enhancing reliability of an electrical signal may also be provided. In other words, arranging the data line DL at a relatively upper side reduces power consumption and mitigates risks associated with its placement. This arrangement not only decreases power consumption when operating the sub-pixel SP but also enhances the reliability of the electrical signals.

The emission structure EMS may be arranged on the anode electrode AE exposed from the pixel defining layer PDL, and may be arranged over the first to third sub-pixels SP1 to SP3. As described above, the emission structure EMS may be at least partially disconnected or bent in the boundary area BDA by the trench TRCH. Accordingly, the risk of leakage current may be reduced, and the sub-pixels SP may have operation characteristics having improved reliability. In other words, the emission structure EMS may be arranged on the anode electrode AE exposed from the pixel defining layer PDL and may span the first to third sub-pixels SP1 to SP3. The trench TRCH partially disconnects or bends the emission structure EMS in the boundary area BDA, reducing the risk of leakage current and improving the reliability of operation characteristics of the sub-pixel SP.

The emission structure EMS may include a multilayer structure electrically connected between the anode electrode AE and the cathode electrode CE.

The emission structure EMS may include an emission unit EU including a plurality of layers. In one or more embodiments, the emission unit EU may include a plurality of emission structures EMS each including a hole transport component HTU, an emission layer (or a light generation layer) EML, and/or an electron transport component ETU. Each of the layers (e.g., the emission layer EML) that form the emission structure EMS may include an organic material and, in one or more embodiments, may further include an inorganic material, such as a metal-containing compound and/or quantum dot.

The hole transport component HTU may include a multilayer structure including a plurality of layers respectively including different materials. For example, the hole transport component HTU may include a hole injection layer HIL and a hole transport layer HTL and, in one or more embodiments, may further include an auxiliary emission layer, an electron blocking layer, and/or the like.

The emission layer EML may include material capable of emitting light of a color. The emission layer EML may include a host and a dopant. The host of the emission layer EML may be emission material capable of capturing carriers (electrons and holes) for light generation, thus inducing efficient exciton generation. The dopant may include a phosphorescent dopant and/or a fluorescent dopant. In one or more embodiments, examples of the dopant are not specifically limited. In one or more embodiments, the dopant may include an organic material, metal complex, and/or the like.

The electron transport component ETU may include a multilayer structure including a plurality of layers respectively including different materials. The electron transport component ETU may include an electron injection layer EIL and an electron transport layer ETL and, in one or more embodiments, may further include an electron buffer layer, a hole blocking layer, and/or the like.

In one or more embodiments (refer to FIG. 7), the emission structure EMS may include a single emission unit EU. In some embodiments, the emission structure EMS may include different materials in the respective sub-pixels SP. For example, the emission structure EMS may include a first emission structure arranged in the first sub-pixel SP1 and including a material for emitting light of a first color, a second emission structure arranged in the second sub-pixel SP2 and including a material for emitting light of a second color, and a third emission structure arranged in the third sub-pixel SP3 and including a material for emitting light of a third color.

In one or more embodiments (refer to FIG. 8), the emission structure EMS may have a tandem structure. For example, the emission structure EMS may include a plurality of emission units EU and a charge generation layer CGL arranged between the plurality of emission units EU. The charge generation layer CGL may be arranged between the emission units EU so as to guide the flow of current. In one or more embodiments, the charge generation layer CGL may have a stacked structure including a p-dopant layer and an n-dopant layer. In one or more embodiments, the emission units EU may include a first emission unit EU1 to provide light of a first color, a second emission unit EU2 to provide light of a second color, and/or a third emission unit EU3 to provide light of a third color. The charge generation layer CGL may include a first charge generation layer CGL1 and a second charge generation layer CGL2. In one or more embodiments, in the emission structure EMS, the first emission unit EU1, the first charge generation layer CGL1, the second emission unit EU2, the second charge generation layer CGL2, and the third emission unit EU3 may be sequentially arranged.

The cathode electrode CE may be arranged on the emission structure EMS. The cathode electrode CE may be provided in common in the first to third sub-pixels SP1 to SP3. The cathode electrode CE may function as a half mirror, partially transmitting and partially reflecting light emitted from the emission structure EMS. However, the present disclosure is not limited to the aforementioned example.

Next, a display device 100 in accordance with one or more embodiments will be described with reference to FIG. 9. Description overlapping with the details mentioned above will be simplified, or may not be repeated.

Referring to FIG. 9, the display device 100 in accordance with the present embodiments differs from the display device 100 according to the foregoing embodiments. For example, the display device 100 shown in FIG. 9 may further include a second layer L2 including an upper conductive layer UCL.

In one or more embodiments, the pixel circuit layer PCL may include a first layer L1 and a second layer L2.

In one or more embodiments, the first layer L1 may be in a form of a substrate SUB, an anode connection transistor T_SP, a first interlayer insulating layer ILD1, first and second conductive pattern layers CP1 and CP2, a data connection conductive layer CL_D, a second interlayer insulating layer ILD2, a lower conductive layer LCL, a third interlayer insulating layer ILD3, and/or a data line DL.

The second layer L2 may be arranged on the first layer L1. In one or more embodiments, the second layer L2 may include an upper conductive layer UCL, a first upper interlayer insulating layer UILD1, a second upper interlayer insulating layer UILD2, and/or a via layer VIA. The upper conductive layer UCL may include a first upper conductive layer UCL1 and a second upper conductive layer UCL2.

The first upper interlayer insulating layer UILD1 may cover the second lower conductive layer LCL2 and the data lines DL, and may be arranged on the third interlayer insulating layer ILD3. The first upper interlayer insulating layer UILD1 may include organic material or inorganic material.

The first upper conductive layer UCL1 may be arranged on the first upper interlayer insulating layer UILD1. The first upper conductive layer UCL1 may be electrically connected to the second lower conductive layer LCL2 through a contactor passing through the first upper interlayer insulating layer UILD1. The first upper conductive layer UCL1 may include conductive material.

The first upper conductive layer UCL1 may be arranged to correspond to each of the first to third sub-pixels SP1 to SP3. The first upper conductive layer UCL1 may include a plurality of first upper conductive layers UCL1 that are respectively arranged in the first to third sub-pixels SP1 to SP3. In one or more embodiments, the first upper conductive layer UCL1 may overlap the second lower conductive layer LCL2 in a plan view.

The second upper interlayer insulating layer UILD2 may cover the first upper conductive layer UCL1, and may be arranged on the first upper interlayer insulating layer UILD1. The second upper interlayer insulating layer UILD2 may include organic material or inorganic material.

The second upper conductive layer UCL2 may be arranged on the second upper interlayer insulating layer UILD2. The second upper conductive layer UCL2 may be electrically connected to the first upper conductive layer UCL1 through a contactor passing through the second upper interlayer insulating layer UILD2. The second upper conductive layer UCL2 may include conductive material.

The second upper conductive layer UCL2 may be arranged to correspond to each of the first to third sub-pixels SP1 to SP3. The second upper conductive layer UCL2 may include a plurality of second upper conductive layers UCL2 respectively arranged in the first to third sub-pixels SP1 to SP3. In one or more embodiments, the second upper conductive layer UCL2 may overlap the first upper conductive layer UCL1 in a plan view.

In one or more embodiments, a conductive layer arranged in substantially the same layer as the second upper conductive layer UCL2 may not be arranged in an area overlapping the data line DL, in a plan view.

The via layer VIA may cover the second upper conductive layer UCL2, and may be arranged on the second upper interlayer insulating layer UILD2. In one or more embodiments, the second upper conductive layers UCL2 and the first to third anode electrodes AE1 to AE3 may be electrically connected to each other through the first to third contactors CNN1 to CNT3 formed in the via layer VIA. In one or more embodiments, the upper conductive layer UCL may be on the lower conductive layer LCL, and may electrically connect the lower conductive layer LCL and the anode electrode AE, and may be covered with the via layer VIA.

Likewise, in the present embodiments, because the trench TRCH may be arranged between the anode electrode AE and the data line DL, the coupling capacitance may be reduced. In addition, because no other conductive structure is formed above the data line DL (e.g., between the data line DL and the pixel defining layer PDL), the capacitance formed in the data line DL by other conductive structures may be reduced, and the power consumption may be reduced. In other words, placing the trench TRCH between the anode electrode AE and the data line DL) may reduce coupling capacitance. Additionally, because no other conductive structures are formed above the data line DL, the capacitance and power consumption may be further reduced.

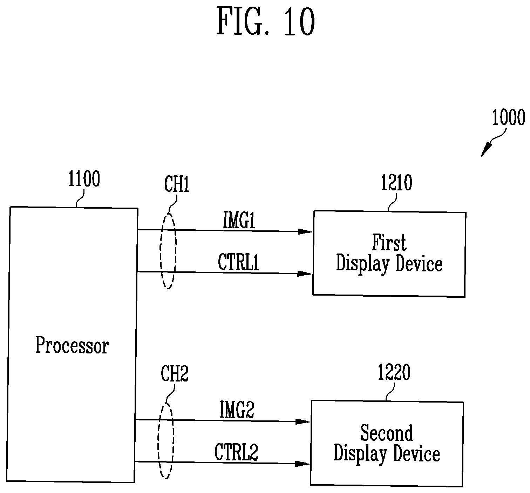

FIG. 10 is a block diagram illustrating one or more embodiments of an electronic device 1000.

Referring to FIG. 10, the electronic device 1000 may include a processor 1100, and one or more display devices 1210 and 1220. The electronic device 1000 may implement a display system.

The processor 1100 may perform one or more suitable tasks and operations. In one or more embodiments, the processor 1100 may include an application processor, a graphic processor, a microprocessor, a central processing unit (CPU), and/or the like. The processor 1100 may be connected to the other components of the electronic device 1000 through a bus system to control the components.

According to an embodiment, the processor 1100 may provide input image data to the display device 1210, 1220, and the display device 1210, 1220 may display images based on the input image data provided by the processor 1100.

In FIG. 10, the electronic device 1000 including the first and second display devices 1210 and 1220 may be illustrated. The processor 1100 may be connected to the first display device 1210 through a first channel CH1, and may be connected to the second display device 1220 through a second channel CH2.

The processor 1100 may be to transmit first image data IMG1 and a first control signal CTRL1 to the first display device 1210 through the first channel CH1. The first display device 1210 may display an image based on the first image data IMG1 and the first control signal CTRL1. The first display device 1210 may be configured in substantially the same manner as the display device 100 described above.

The processor 1100 may be to transmit second image data IMG2 and a second control signal CTRL2 to the second display device 1220 through the second channel CH2. The second display device 1220 may display an image based on the second image data IMG2 and the second control signal CTRL2. The second display device 1220 may be configured in substantially the same manner as the display device 100 described above.

The electronic device 1000 may include computing systems that provide an image display function, such as a portable computer, a mobile phone, a smart phone, a tablet personal computer (tablet PC), a smart watch, a watch phone, a portable multimedia player, a navigation system, and/or an ultra mobile personal computer (UMPC). Furthermore, the electronic device 1000 may include at least one of a head-mounted display (HMD) device, a virtual reality (VR) device, a mixed reality (MR) device, and/or an augmented reality (AR) device.

According to an embodiment, the electronic device 1000 may further include a memory device, a storage device, an input/output(I/O) device, a power supply.

The memory device may store data needed to perform the operation of the electronic device 1000. The memory device may function as a working memory and/or a buffer memory for the processor 1100. For example, the memory device may include one or more volatile memory devices such as a dynamic random access memory (DRAM) device, a static random access memory (SRAM) device, and a mobile DRAM device.

The storage device may store data in response to control signals or data from the processor 1100. The storage device may include one or more non-volatile storages to retain the data even when the electronic device 1000 is powered off. In some embodiments, the storage device may include a solid state drive (SSD), a hard disk drive (HDD), a compact disc read-only memory (CD-ROM), or the like.

The I/O device may include input devices such as a keyboard, a keypad, a touchpad, a touch screen, and a mouse, and output devices such as a speaker and a printer. In an embodiment, the display device 1210 and 1220 may be included in the I/O device.

The power supply may supply power needed to perform the operation of the electronic device 1000. For example, the power supply may be a power management integrated circuit (PMIC). In an embodiment, the power supply may supply power to the display device 1210 and 1220.

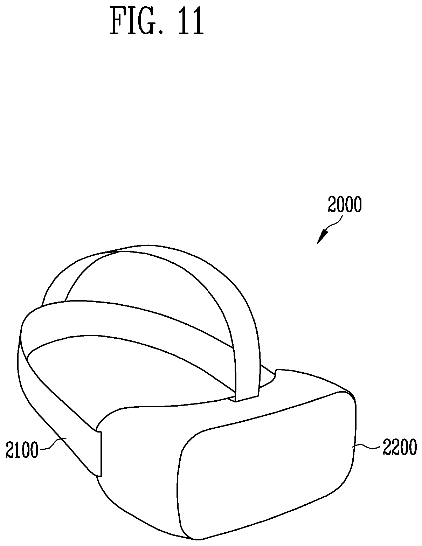

FIG. 11 is a perspective diagram illustrating an application example of the electronic device 1000 of FIG. 10.

Referring to FIG. 11, the electronic device 1000 of FIG. 10 may be applied to a head-mounted display device 2000. The head-mounted display device 2000 may be a wearable electronic device, which may be worn on the head of the user.

The head-mounted display device 2000 may include a head-mounted band 2100 and a display device reception casing 2200. The head-mounted band 2100 may be connected to the display device reception casing 2200. The head-mounted band 2100 may include a horizontal band and/or a vertical band to fasten the head-mounted display device 2000 to the head of the user. The horizontal band may enclose the sides of the head of the user, and the vertical band may enclose the top of the head of the user. However, one or more embodiments are not limited to the aforementioned example. For example, the head-mounted band 2100 may be implemented in the form of eyeglass frames, a helmet, and so on.

The display device reception casing 2200 may receive the first and second display devices 1210 and 1220. The display device reception casing 2200 may further receive the processor 1100.

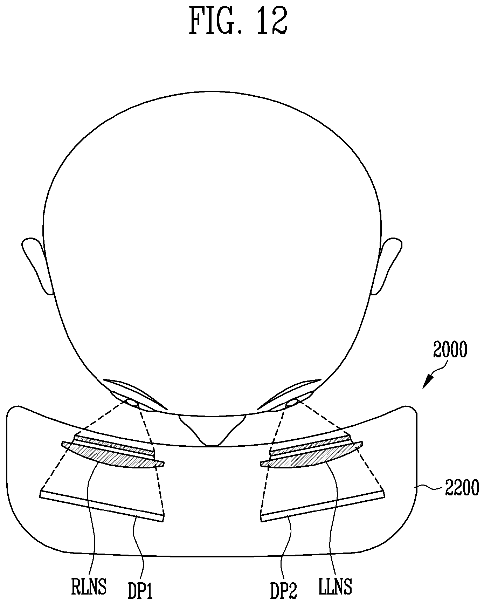

FIG. 12 is a diagram illustrating the head-mounted display device 2000 of FIG. 11 that is worn on the head of the user.

Referring to FIG. 12, the first display panel DP1 of the first display device 1210 and the second display panel DP2 of the second display device 1220 are arranged in the head-mounted display device 2000. The head-mounted display device 2000 may further include one or more lenses (e.g., the left-eye lens LLNS and the right-eye lens RLNS).

In the display device reception casing 2200, the right-eye lens RLNS may be positioned between the first display panel DP1 and the right eye of the user. In the display device reception casing 2200, the left-eye lens LLNS may be positioned between the second display panel DP2 and the left eye of the user.

An image outputted from the first display panel DP1 can be viewed by the right eye of the user through the right-eye lens RLNS. The right-eye lens RLNS may refract light emitted from the first display panel DP1 toward the right eye of the user. The right-eye lens RLNS may perform an optical function to adjust a viewing distance between the first display panel DP1 and the right eye of the user.

An image outputted from the second display panel DP2 may be viewed by the left eye of the user through the left-eye lens LLNS. The left lens LLNS may refract light emitted from the second display panel DP2 toward the left eye of the user. The left-eye lens LLNS may perform an optical function to adjust a viewing distance between the second display panel DP2 and the left eye of the user.

In one or more embodiments, each of the right-eye lens RLNS and the left-eye lens LLNS may include an optical lens having a pancake-shaped cross-section (e.g., an optical lens in a shape of a pancake). In one or more embodiments, each of the right-eye lens RLNS and the left-eye lens LLNS may include a multi-channel lens including sub-areas having different optical characteristics. In some embodiments, each display panel (e.g., the first display panel DP1 or the second display panel DP2) may output images respectively corresponding to sub-areas of the multi-channel lens. The output images may be viewed to the user through the corresponding sub-areas.

An embodiment of the present disclosure may provide a display device with improved reliability of electrical signals.

An embodiment of the present disclosure may provide a display device capable of improving power consumption characteristics.

As utilized herein, the terms "substantially," "about," and similar terms are used as terms of approximation and not as terms of degree, and are intended to account for the inherent deviations in measured or calculated values that would be recognized by those of ordinary skill in the art. "About" or "approximately," as used herein, is also inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

In the context of the present disclosure and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

A display device, a manufacturing device thereof, and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the present disclosure.

While one or more suitable embodiments have been described above, those skilled in the art will appreciate that one or more suitable modifications, additions and substitutions are possible, without departing from the scope of the present disclosure as defined in the claims. A person of ordinary skill in the art, in view of the present disclosure in its entirety, would appreciate that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Therefore, one or more embodiments disclosed in this specification are only for illustrative purposes.

Embodiments are set out in the following clauses:
1. A display device, comprising:
   a pixel circuit layer including a substrate disposed on a plane, a pixel circuit formed on the substrate, a data line electrically connected to the pixel circuit, and a via layer covering the pixel circuit and the data line;
   a light emitting element disposed on the pixel circuit layer, and including an anode electrode, a cathode electrode, and an emission structure electrically connected between the anode electrode and the cathode electrode; and
   a pixel defining layer disposed on the pixel circuit layer, and covering a portion of the anode electrode,
   wherein a trench passing both through the pixel defining layer and through a portion of the via layer is formed in an area adjacent to the anode electrode, and
   wherein the trench is disposed between the anode electrode and the data line when viewed on the plane.
2. The display device of clause 1, wherein an imaginary line connecting the anode electrode and the data line passes through the trench.
3. The display device of clause 1 or clause 2, wherein an air layer is formed in the trench.
4. The display device of any preceding clause, including an emission area where the light emitting element provides light,
   wherein the trench is formed in a peripheral portion of the emission area.
5. The display device of clause 4, including a first sub-pixel configured to provide light of a first color; a second sub-pixel configured to provide light of a second color; and a third sub-pixel configured to provide light of a third color,
   wherein the emission area includes a first emission area forming the first sub-pixel, a second emission area forming the second sub-pixel, and a third emission area forming the third sub-pixel, and
   wherein the trench includes a first trench enclosing the first emission area, a second trench enclosing the second emission area, and a third trench enclosing the third emission area.
6. The display device of clause 5,
   wherein the pixel circuit comprises a first pixel circuit included in the first sub-pixel, a second pixel circuit included in the second sub-pixel, and a third pixel circuit included in the third sub-pixel, and
   wherein the data line comprises a first data line electrically connected to the first pixel circuit, a second data line electrically connected to the second pixel circuit, and a third data line electrically connected to the third pixel circuit.
7. The display device of clause 6,
   wherein the first emission area, the second emission area, and the third emission area are adjacent to each other in a first direction, and
   wherein the first data line, the second data line, and the third data line extend in a second direction different from the first direction, and are respectively disposed on one side of the first emission area, the second emission area, and the third emission area.
8. The display device of clause 7, wherein each of the first emission area, the second emission area, and the third emission area has a rectangular shape.
9. The display device of any of clauses 6 to 8,
   wherein the second emission area and the third emission area are adjacent to each other in a first direction, and
   wherein the first emission area is adjacent to the second emission area and the third emission area in a diagonal direction inclined to both the first direction and a second direction perpendicular to the first direction.
10. The display device of clause 9, wherein at least a portion of the data line extends in the diagonal direction, and at least another portion of the data line extends in the second direction.
11. The display device of clause 9 or clause 10,
   wherein the data line is formed of a single line in each of an area between the first trench and the second trench and an area between the first trench and the third trench, and
   wherein the data line is formed of a plurality of lines in an area between the second trench and the third trench.
12. The display device of clause 11,
   wherein between the first trench and the second trench, a portion of the second data line is disposed without the first data line and the third data line being disposed,
   wherein between the first trench and the third trench, a portion of the first data line is disposed without the second data line and the third data line being disposed, and
   wherein between the second trench and the third trench, a portion of the first data line and a portion of the second data line are disposed without the third data line being disposed.
13. The display device of clause 12, wherein each of the first emission area, the second emission area, and the third emission area has a hexagonal shape.
14. The display device of any preceding clause,
   wherein the substrate comprises a silicon substrate, and
   wherein at least a portion of the emission structure is disconnected by the trench.
15. The display device of any preceding clause,
   wherein the pixel circuit includes a transistor, and
   wherein the transistor is electrically connected to the anode electrode through two or more conductive layers.
16. The display device of clause 15, wherein no conductive structure is formed between the data line and the pixel defining layer.
17. The display device of clause 16, further comprising a data connection conductive layer disposed between the substrate and the data line,
   wherein a data signal supplied through the data line is applied to the data connection conductive layer disposed under the data line.
18. The display device of clause 17, wherein the two or more conductive layers include a lower conductive layer, and the lower conductive layer electrically connects the transistor and the anode electrode to each other.
19. The display device of clause 18, wherein the two or more conductive layers further include an upper conductive layer disposed on the lower conductive layer, and electrically connecting the lower conductive layer and the anode electrode, and covered with the via layer.
20. A display device, comprising:
   sub-pixels formed on a substrate disposed on a plane defined based on a first direction and a second direction perpendicular to the first direction, and including a first sub-pixel including a first emission area, a second sub-pixel including a second emission area, and a third sub-pixel including a third emission area,
   wherein each of the sub-pixels comprises:
      a light emitting element including an anode electrode, a cathode electrode, and an emission structure electrically connected between the anode electrode and the cathode electrode;
      a pixel circuit electrically connected to the light emitting element; and
      a data line electrically connected to the pixel circuit,
      wherein the emission structure is disposed over the sub-pixels, and at least a portion of the emission structure is disconnected by a trench formed in a boundary area between the sub-pixels,
      wherein the trench includes a first trench formed around the first emission area, a second trench formed around the second emission area, and a third trench formed around the third emission area, and is spaced apart from the data line on the plane,
      wherein the second emission area and the third emission area are adjacent to each other in the first direction, and a boundary area between the second emission area and the third emission area overlaps the first emission area in the second direction,
      wherein the data line is formed of a single line in each of an area between the trench and the second trench and an area between the first trench and the third trench, and
      wherein the data line is formed of a plurality of lines in an area between the second trench and the third trench.

## Claims

1. A display device, comprising:
a pixel circuit layer comprising a substrate on a plane, a pixel circuit on the substrate, a data line electrically connected to the pixel circuit, and a via layer covering the pixel circuit and the data line;
a light emitting element on the pixel circuit layer, and comprising an anode electrode, a cathode electrode, and an emission structure electrically connected between the anode electrode and the cathode electrode; and
a pixel defining layer on the pixel circuit layer, and covering a portion of the anode electrode,
wherein a trench passing both through the pixel defining layer and through a portion of the via layer is in an area adjacent to the anode electrode, and
wherein the trench is between the anode electrode and the data line in a plan view of the display device.

2. The display device of claim 1, wherein an imaginary line connecting the anode electrode and the data line passes through the trench.

3. The display device of claim 1 or claim 2, wherein an air layer is in the trench, and
wherein the display device further comprises an emission area where the light emitting element is to provide light,
wherein the trench is in a peripheral portion of the emission area.

4. The display device of claim 3, further comprising a first sub-pixel to provide light of a first color, a second sub-pixel to provide light of a second color, and a third sub-pixel to provide light of a third color,
wherein the emission area comprises a first emission area corresponding to the first sub-pixel, a second emission area corresponding to the second sub-pixel, and a third emission area corresponding to the third sub-pixel, and
wherein the trench comprises a first trench enclosing the first emission area, a second trench enclosing the second emission area, and a third trench enclosing the third emission area.

5. The display device of claim 4,
wherein the pixel circuit comprises a first pixel circuit in the first sub-pixel, a second pixel circuit in the second sub-pixel, and a third pixel circuit in the third sub-pixel,
wherein the data line comprises a first data line electrically connected to the first pixel circuit, a second data line electrically connected to the second pixel circuit, and a third data line electrically connected to the third pixel circuit,
wherein the first emission area, the second emission area, and the third emission area are adjacent to each other in a first direction, and
wherein the first data line, the second data line, and the third data line are extended in a second direction different from the first direction, and are arranged on one side of the first emission area, on one side of the second emission area, and on one side of the third emission area, respectively.

6. The display device of claim 5, wherein each of the first emission area, the second emission area, and the third emission area has a rectangular shape.

7. The display device of claim 5 or claim 6,
wherein the second emission area and the third emission area are adjacent to each other in the first direction,
wherein the first emission area is adjacent to the second emission area and the third emission area in a diagonal direction inclined to both the first direction and a second direction perpendicular to the first direction, and
wherein at least a portion of the data line is extended in the diagonal direction, and at least another portion of the data line is extended in the second direction.

8. The display device of claim 7,
wherein the data line is in a form of a single line in each of an area between the first trench and the second trench and an area between the first trench and the third trench,
wherein the data line is in a form of a plurality of lines in an area between the second trench and the third trench,
wherein between the first trench and the second trench, a portion of the second data line is arranged without the first data line and the third data line being arranged,
wherein between the first trench and the third trench, a portion of the first data line is arranged without the second data line and the third data line being arranged, and
wherein between the second trench and the third trench, a portion of the first data line and a portion of the second data line are arranged without the third data line being arranged.

9. The display device of claim 8, wherein each of the first emission area, the second emission area, and the third emission area has a hexagonal shape.

10. The display device of any preceding claim,
wherein the substrate comprises a silicon substrate,
wherein at least a portion of the emission structure is disconnected by the trench,
wherein the pixel circuit comprises a transistor, and
wherein the transistor is electrically connected to the anode electrode through two or more conductive layers.

11. The display device of claim 10, wherein no conductive structure is between the data line and the pixel defining layer.

12. The display device of claim 11, further comprising a data connection conductive layer between the substrate and the data line,
wherein a data signal supplied through the data line is applied to the data connection conductive layer under the data line, and
wherein the two or more conductive layers comprise a lower conductive layer, and the lower conductive layer electrically connects the transistor and the anode electrode to each other.

13. The display device of claim 12, wherein the two or more conductive layers further comprise an upper conductive layer on the lower conductive layer, and electrically connecting the lower conductive layer and the anode electrode, and covered with the via layer.

14. A display device, comprising:
sub-pixels on a substrate on a plane defined based on a first direction and a second direction perpendicular to the first direction, and comprising a first sub-pixel comprising a first emission area, a second sub-pixel comprising a second emission area, and a third sub-pixel comprising a third emission area,
wherein each of the sub-pixels comprises:
a light emitting element comprising an anode electrode, a cathode electrode, and an emission structure electrically connected between the anode electrode and the cathode electrode;
a pixel circuit electrically connected to the light emitting element; and
a data line electrically connected to the pixel circuit,
wherein the emission structure is arranged over the sub-pixels, and at least a portion of the emission structure is disconnected by a trench in a boundary area between the sub-pixels,
wherein the trench comprises a first trench around the first emission area, a second trench around the second emission area, and a third trench around the third emission area, and is spaced apart from the data line on the plane,
wherein the second emission area and the third emission area are adjacent to each other in the first direction, and a boundary area between the second emission area and the third emission area overlaps the first emission area in the second direction,
wherein the data line is in a form of a single line in each of an area between the trench and the second trench and an area between the first trench and the third trench, and
wherein the data line is in a form of a plurality of lines in an area between the second trench and the third trench.

15. An electronic device, comprising:
a processor configured to provide input image data;
a display device according to any of claims 1 to 13, configured to display an image based on the input image data, the display device including sub-pixel areas; and
a power supply configured to supply power to the display device.
